# EUROPEAN PATENT SPECIFICATION

(11) **EP 1 858 058 B1**
(45) Date of publication and mention of the grant of the patent: **11.01.2012**
(21) Application number: 06712518.7
(22) Date of filing: 27.01.2006
(51) Int. Cl.: H01L 21/673

(54) **FIXATION CARRIER, PRODUCTION METHOD OF FIXATION CARRIER, USE METHOD OF FIXATION CARRIER, AND SUBSTRATE RECEPTION CONTAINER**
BEFESTIGUNGSTRÄGER, HERSTELLUNGSVERFAHREN FÜR EINEN BEFESTIGUNGSTRÄGER, VERWENDUNGSVERFAHREN FÜR EINEN BEFESTIGUNGSTRÄGER UND SUBSTRATAUFNAHMEBEHÄLTER
DISPOSITIF DE TRANSPORT PAR FIXATION, SON PROCEDE DE FABRICATION, SON PROCEDE D'UTILISATION ET CONTENANT DE RECEPTION DE SUBSTRAT

(30) Priority: 03.02.2005 JP 2005027910; 28.04.2005 JP 2005132385; 10.05.2005 JP 2005137537
(43) Date of publication of application: 21.11.2007
(73) Proprietor: SHIN-ETSU POLYMER CO., LTD., Tokyo 103-0023 (JP)
(72) Inventor: ODASHIMA, Satoshi, a-shi, Saitama, 3360031 (JP); HOSONO, Noriyoshi, 3 (JP)
(74) Representative: Luderschmidt, Schüler & Partner
(86) International application number: PCT/JP2006/301352
(87) International publication number: WO 2006/087894

(56) References cited:
- EP-A2- 1 463 094
- JP-A- 05 335 405
- JP-A- 2000 142 874
- US-A- 4 778 326

## Description

### Technical Field

The present invention relates to a fixing carrier for items to be loaded, such as substrates typified by semiconductor wafers, quartz glass, etc., printed circuit boards, chip parts and others that are difficult to handle by themselves, as well as relating to the manufacturing method of the fixing carrier, method of using the fixing carrier and a substrate storage container.

### Background Art

Recently, there has been a trend towards enlargement of semiconductor wafers in diameter from 200 mm to 300 mm. A 300 mm type semiconductor wafer is formed with circuit patterns on the obverse side, then protective tape for backgrinding is stuck on the obverse side taking into consideration packaging requests for a layered structure, etc., then the wafers are subjected to a thinning process in which the reverse side of the wafer is thinned or background by a backgrinding machine, and followed by a dicing process where the protective tape is peeled off and dicing tape for the dicing process is stuck on.

The semiconductor wafers with dicing tape thus stuck thereon should be shipped from a factory to another so that they are formed into IC chips, which in turn are mounted on dedicated carriers and subj ected to bonding, sealing and other manufacturing processes (see Patent document 1). Patent document 1: Japanese Patent Application Laid-open Sho 59-2271195. Reference is likewise made to prior art documents EP1,463,094 and JP 2000142874.

### Disclosure of Invention

### Problems to be Solved by the Invention

Thus, the conventional semiconductor wafers are processed as above, hence become easy to warp and crack because they are markedly thinned by backgrinding. As a result there is a serious problemthat it is remarkably difficult to properly transport them from one factory to another without damaging them.
As the method for solving this problem, use of the aforementioned dedicated carrier can be considered. However, this carrier is dedicated to, and only for, in-plant transportation, so that it cannot be used for a long-term shipment from one plant to another because it is not one that is designed taking into account severe shipment conditions, etc.

Further, if dicing tape has been stuck to the semiconductor wafers for a long period during shipment from one plant to another, there is more than a small risk of the adhesive of the dicing tape transferring to bumps of circuits, causing troubles.

The present invention according o claim 1 has been devised in view of the above, it is therefore an object of the present invention to provide a fixing carrier, a fixing carrier manufacturing method, a method of using the fixing carrier and a substrate storage container, which provide proper shipment of items to be loaded that are prone to warp and crack.

### Means for Solving the Problems

In order to solve the above problems, in the present invention, a deformable supporting layer that removably supports an item to be loaded is laid over a base, the fixing carrier includes: a sectioned space formed in the base and covered by the supporting layer; a projection provided in the sectioned space and supporting the supporting layer in contact therewith; and an exhaust passage for drawing air out of the sectioned space that is formed in the base and covered by the supporting layer.

The base may be formed of a flat plate having rigidity and an approximately circular shape, viewed from top while the supporting layer is formed of elastomer.
At least part of the deforming area of the supporting layer may be processed with non-stick treatment.
The deforming area of the supporting layer may be the surface of a non-contact portion where the supporting layer is not in contact with the projection.

The obverse surface at a contact portion where the supporting layer is in contact with the projection may be formed to be a non-sticky surface.
The items to be loaded may be a semiconductor wafer that has been background.
The projection is preferably as high as 0.05 mm or higher.

Multiple projections may be provided so as to create clearance between projections.
The configuration may further include a negative pressure source that is connected to the exhaust passage and draws air out of the sectioned space so as to deform the supporting layer.

Further, in order to solve the above problems, according to the present invention, a fixing carrier manufacturing method for manufacturing any one of the fixing carriers defined in Claims 1 through 9, includes the steps of: placing a concavo-convex surface of a stamper into contact with a thermoplastic resin sheet to heat and press it; and cooling the sheet while pressing it so as to format leastprojection (s), among the base, sectioned space, projection(s) and exhaust passage.
Here, it is preferred that the resin sheet is heated and pressed at a temperature ranging from the glass transition temperature of the resin to 50 deg. C greater than that and cooled at a temperature lower by 20 deg. C or more than the glass transition temperature.

Further, in order to solve the above problems, the present invention is characterized in that an item to be loaded is transported using a fixing carrier defined in any one of Claims 1 to 8.

Further, in order to solve the above problems, the present invention is a substrate storage container for accommodating fixing carriers defined in any one of Claims 1 to 9, comprising: a front-open container body for accommodating fixing carriers; a door element which opens and closes the front face of the container body; and teeth for supporting fixing carriers formed on the walls on both sides of the container body.

It is preferred that each tooth is comprised of a flat plate that is provided on the side wall of the container body so as to extend along the side periphery of the fixing carrier, a front medium-thick area that is formed at the front interior side of the flat plate and supports the fixing carrier; and a rear medium-thick area that is formed in the rear part of the flat plate and supports the fixing carrier.

Here, the base and fixing carrier specified in Claims may be provided in an approximately circular form, approximately elliptic form, approximately rectangular form, approximately polygonal form, etc., viewed from top, and may be those accommodated in a storage container for substrates ormay not be. Examples of items to be loaded, at least, include single or multiple precision substrates, liquid crystal glass, quartz glass, photomasks, circuit boards, chip parts, lead frames for testing, various kinds of sheets, thin electronic parts, etc. In the case where the items to be loaded are precision substrates, semiconductor wafers (Si wafers and GaP wafers) having a diameter of 200 mm, 300 mm, 400 mm and 450 mm are included.

The supporting layer may use various kinds of elastomers and rubbers having flexibility, and either may be bonded to the projections or may not be. At least part of the deforming area of this supporting layer may be processed with non-stick treatment having a pattern of single or multiple straight lines,cross-shaped pattern,X-shaped pattern,spiralpattern, lattice pattern, polka dot pattern, honeycomb pattern, squamous pattern, continuous swastika pattern or a combination of these, or may be processed with non-stick treatment so as to display a company name, predetermined letters and characters etc. The non-stick treatment may be made in any manner as long as it has a size and range that at least provides a trigger function for removal of the item to be loaded.

The projections may be provided in a cylindrical form, prism form, frusto-conical form, frusto-pyramidal form etc.. and whether it is hollow or solid is not particularly limited. Either single or multiple exhaust passages may be provided. The fixing carrier can be used not only to transport from one plant to another but also for in-plant conveyance of the items to be loaded. Though there are various types of substrate storage containers such as FOSB, FOUP, SMALLFOUP, etc., any can be used. The container body of the substrate storage container may be provided in a transparent, opaque or translucent form.

According to the present invention, placing an item to be loaded on the supporting layer laid over the fixing carrier base and pressing it makes it possible to hold the item to be loaded on the supporting layer. Upon this, the item to be loaded is placed into closed contact with the supporting layer, so the item will hardly flex and warp even if it is thin.

### Effect of the Invention

According to the present invention, even if the items to be loaded are semiconductor wafers which are easy to warp and easy to break, it is possible to be effective in performing proper transfer, carrying, conveyance and shipment while preventing damage to the wafers.
Further, when the deforming area of the supporting layer is the surface of a non-contact portion where the supporting layer is not in contact with the front endface of the projection, and at least part of the deforming area of the supporting layer has been processed with non-stick treatment, it is possible to quickly create a flow channel of air between the non-stick treated portion of the supporting layer and the item to be loaded upon deformation of the supporting layer and trigger detachment of the item to be loaded.

When the projection is as high as 0.05 mm or higher, it is possible to secure a sufficient enough height for the sectioned space that is covered by the supporting layer, and enhance smooth flow of air to promote deformation of the supporting layer 8.
Further, when multiple projections are provided so as to create clearance between projections, it is possible to support the supporting layer and the item to be loaded in a stable position and deform the supporting layer by introducing air into the clearance between projections.

When the resin sheet is heated and pressed at a temperature ranging from the glass transition temperature of the resin sheet to 50 deg. C greater than that, and cooled at a temperature lower by 20 deg. C or more than the glass transition temperature, it is possible to prevent occurrence of defects in the resin sheet forming the base and occurrence of variation of the resin sheet thickness, which enables preferable molding.

Further, when each tooth is comprised of a flat plate that is provided on the side wall of the container body and extends along the side periphery of the fixing carrier, a front medium-thick area that is formed at the front interior side of the flat plate and supports the fixing carrier; and a rear medium-thick area that is formed in the rear part of the flat plate and supports the fixing carrier, it is possible to essentially horizontally support the fixing carrier between the front medium-thick areas and the rear medium-thick areas, it is hence possible to prevent the fixing carrier from being inclined in the vertical direction and avoid difficulties in its loading and unloading.

### Brief Description of the Drawings

[FIG. 1]

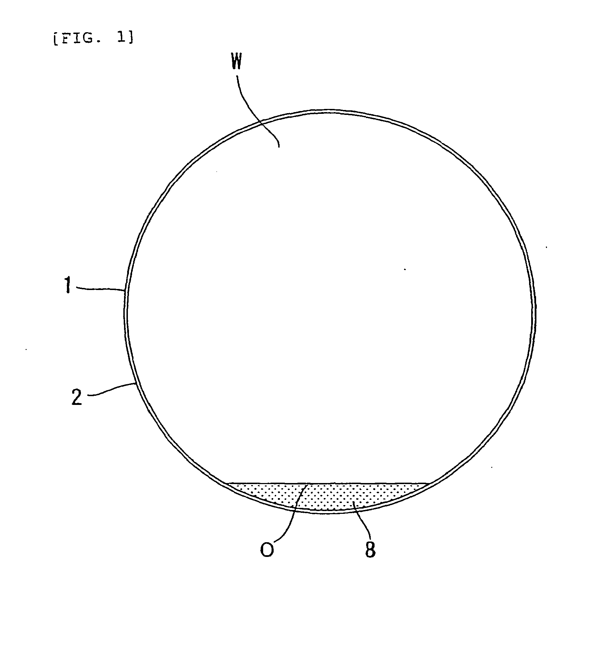

   FIG. 1 is an illustrative plan view schematically showing a semiconductor wafer in its supported state in the embodiment of a fixing carrier according to the present invention.
[FIG. 2]

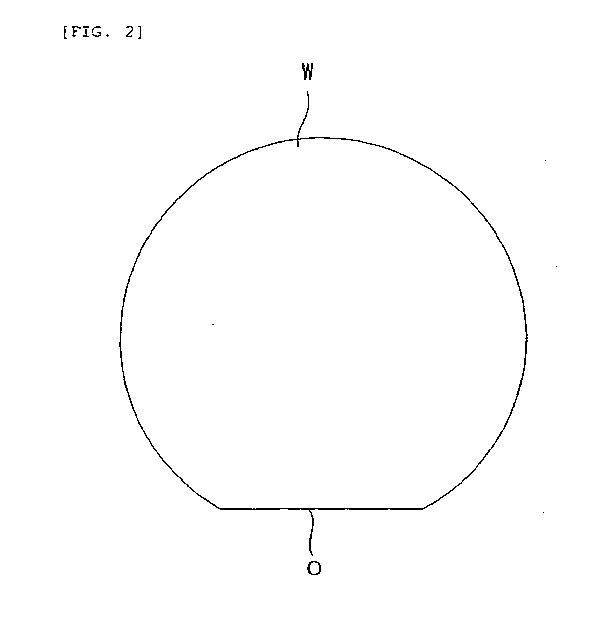

   FIG. 2 is an illustrative plan view schematically showing a semiconductor wafer in the embodiment of a fixing carrier according to the present invention.
[FIG. 3]

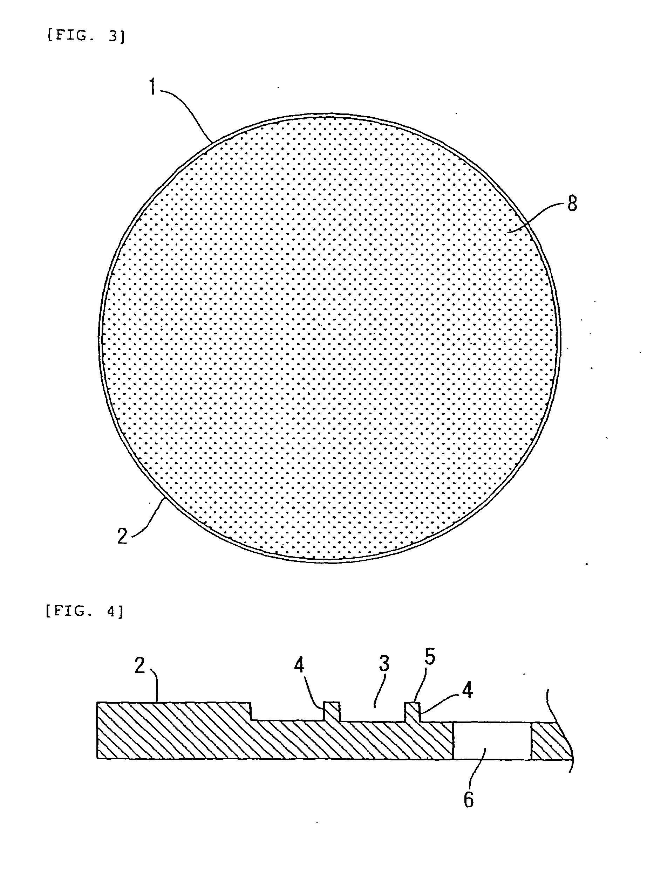

   FIG. 3 is an illustrative plan view schematically showing the embodiment of a fixing carrier according to the present invention.
[FIG. 4]
   FIG. 4 is an illustrative sectional view schematically showing a base and projections in the embodiment of a fixing carrier according to the present invention.
[FIG. 5]

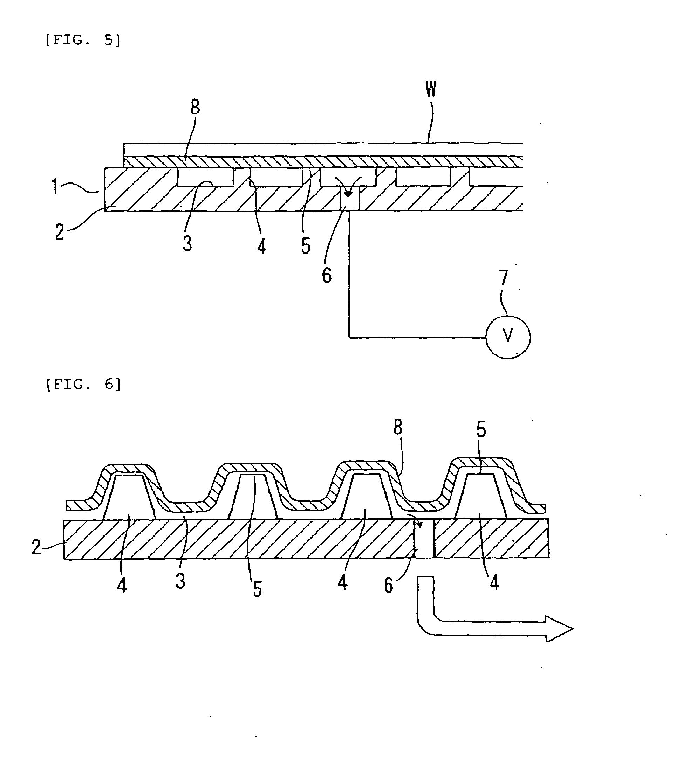

   FIG. 5 is an illustrative sectional view schematically showing the embodiment of a fixing carrier and the method of using the fixing carrier according to the present invention.
[FIG. 6]
   FIG. 6 is an illustrative sectional view schematically showing a deformed state of a supporting layer in the embodiment of a fixing carrier and the method of using the fixing carrier according to the present invention.
[FIG. 7]

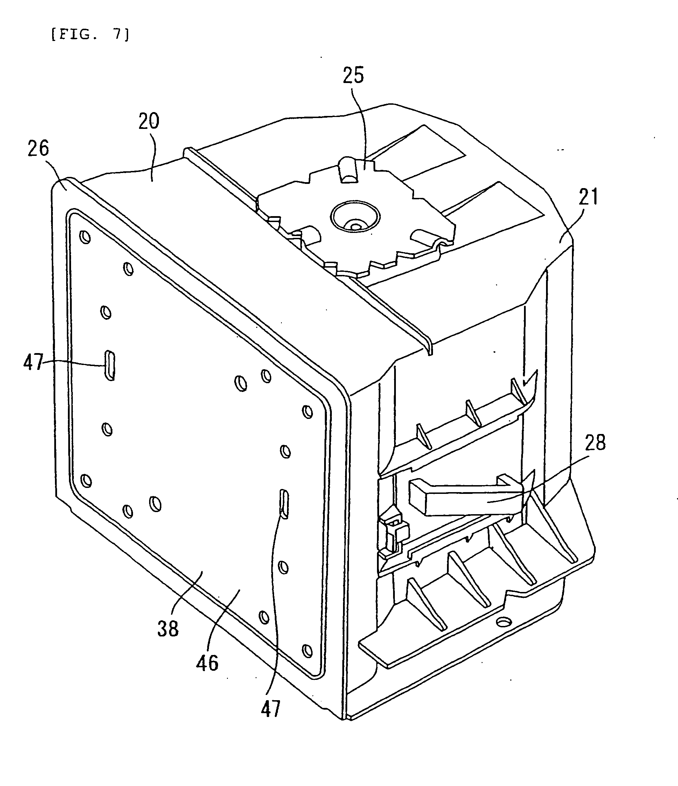

   FIG. 7 is an overall perspective illustration schematically showing the embodiment of a substrate storage container according to the present invention.
[FIG. 8]

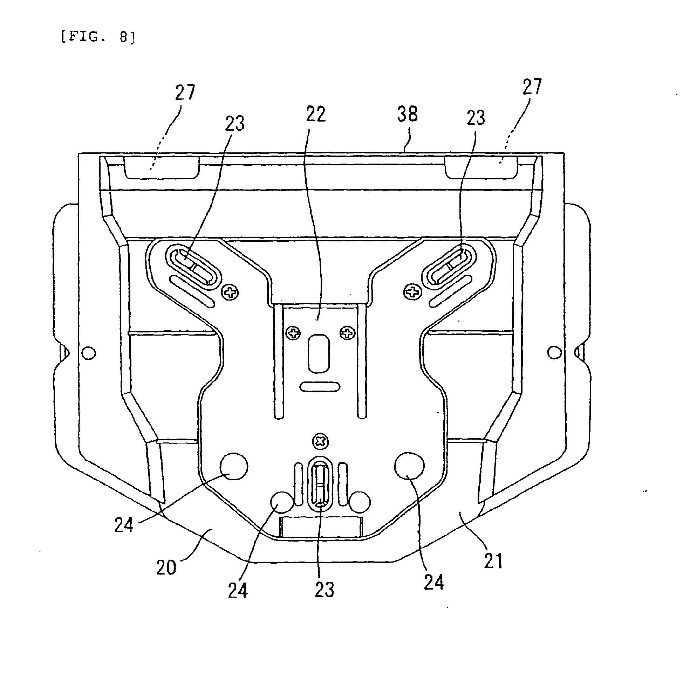

   FIG. 8 is a bottom view schematically showing the embodiment of a substrate storage container according to the present invention.
[FIG. 9]

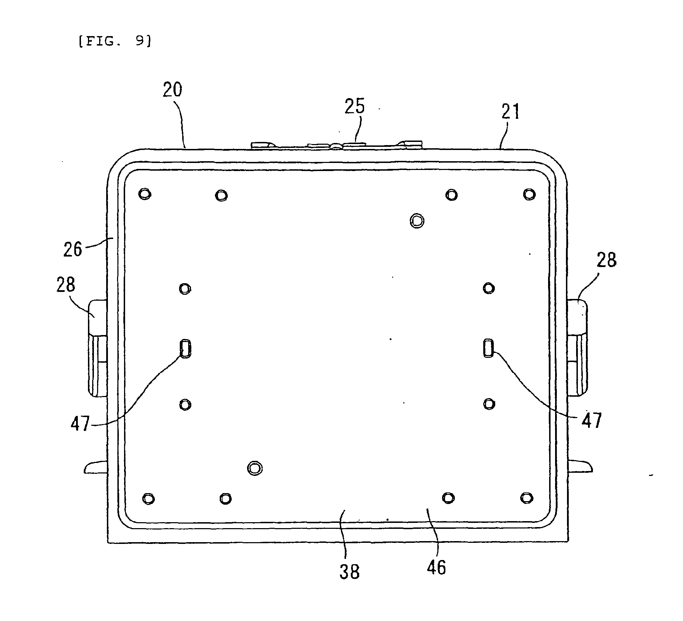

   FIG. 9 is a front illustrative view schematically showing the embodiment of a substrate storage container according to the present invention.
[FIG. 10]

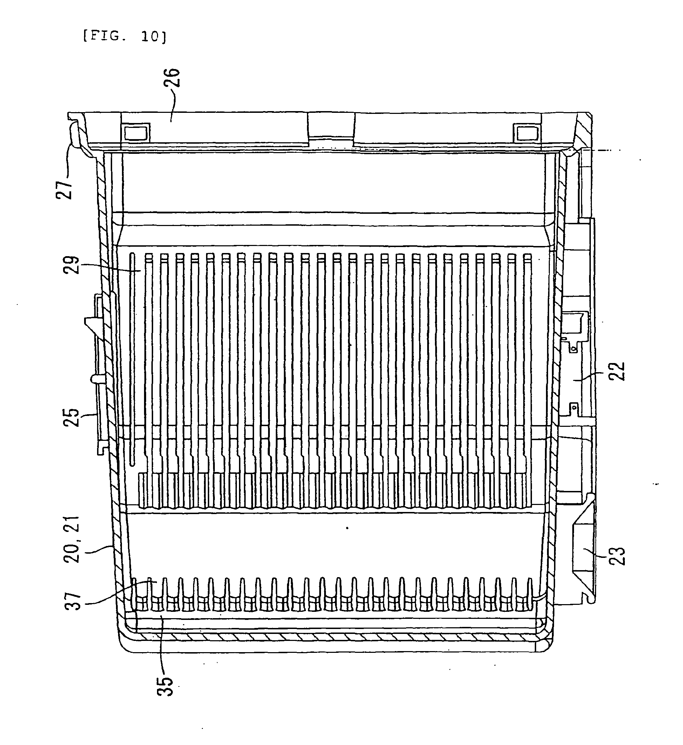

   FIG. 10 is a sectional illustrative view schematically showing a container body in the embodiment of a substrate storage container according to the present invention.
[FIG. 11]

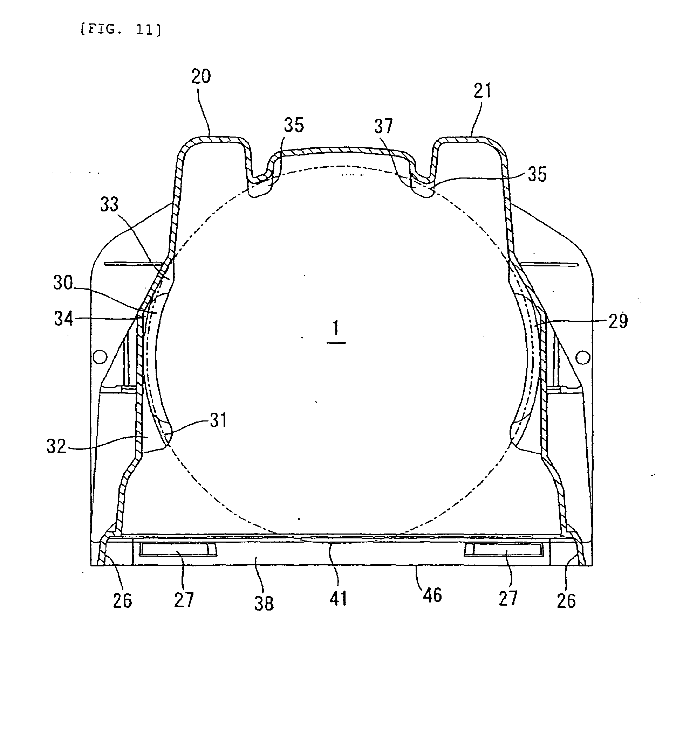

   FIG. 11 is a plan sectional illustration schematically showing a container body accommodating a fixing carrier in the embodiment of a substrate storage container according to the present invention.
[FIG. 12]

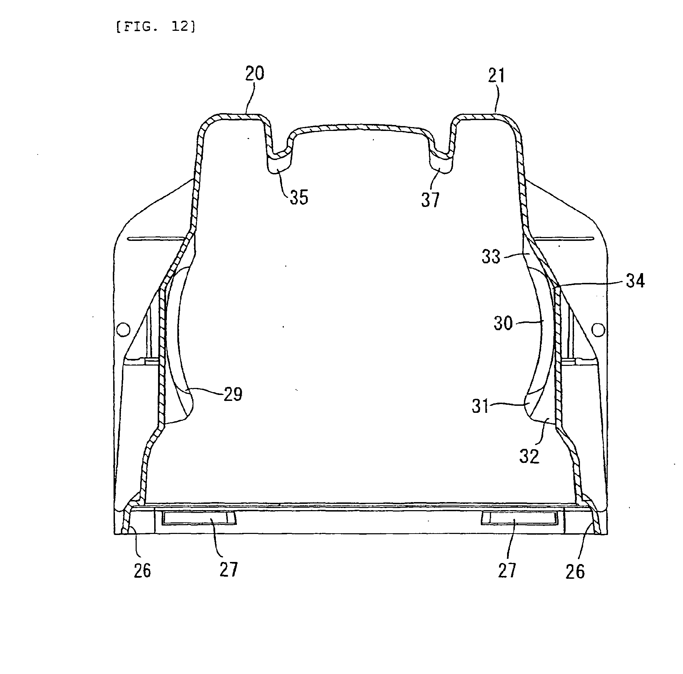

   FIG. 12 is a plan sectional illustration schematically showing a container body in the embodiment of a substrate storage container according to the present invention.
[FIG. 13]

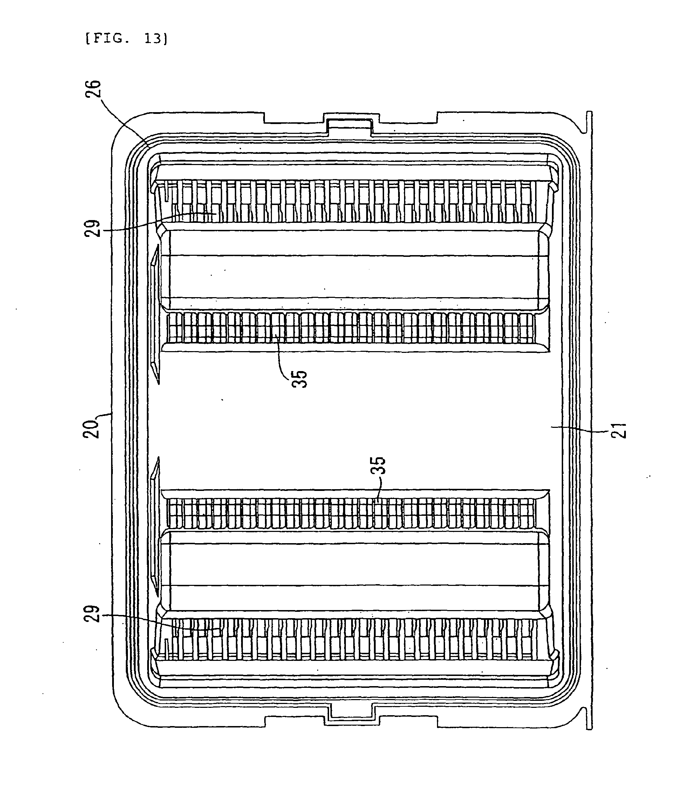

   FIG. 13 is a front illustrative view schematically showing a container body in the embodiment of a substrate storage container according to the present invention.
[FIG. 14]

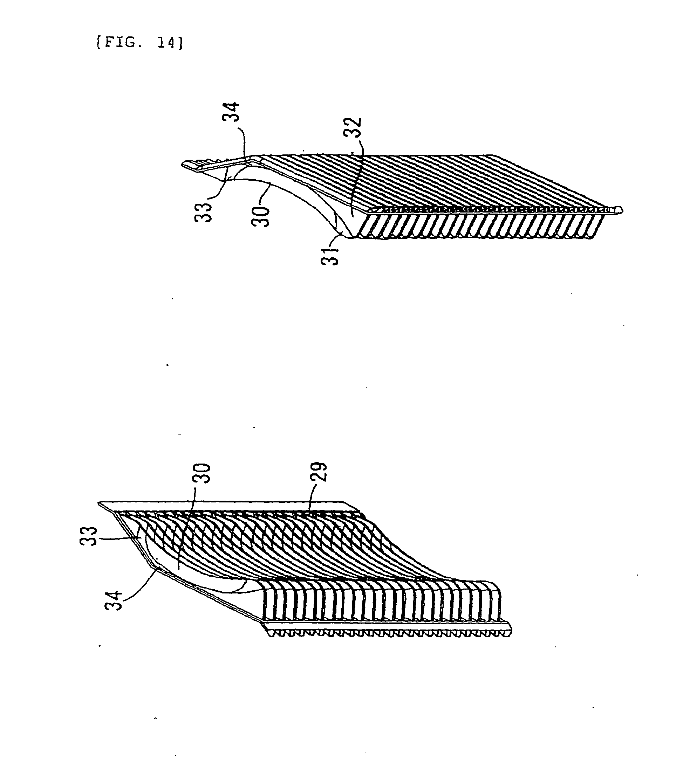

   FIG. 14 is a perspective illustration schematically showing a pair of teeth in the embodiment of a substrate storage container according to the present invention.
[FIG. 15]

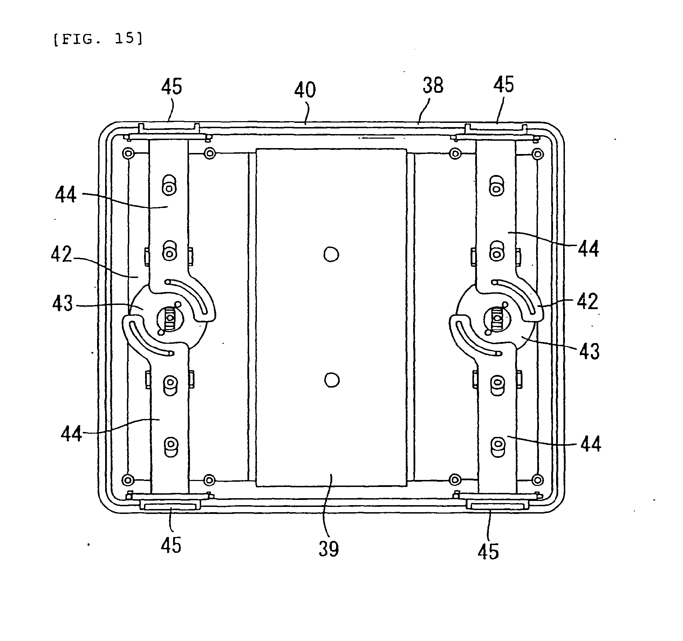

   FIG. 15 is a front illustrative view schematically showing locking mechanisms of a door element in the embodiment of a substrate storage container according to the present invention.
[FIG. 16]

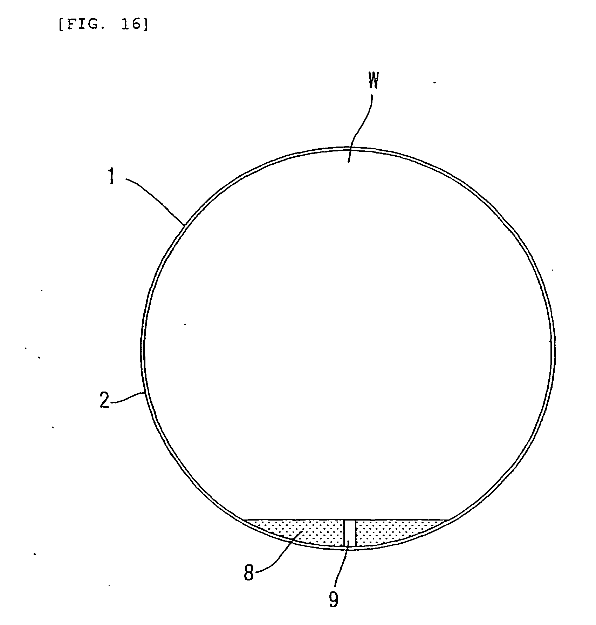

   FIG. 16 is a plan illustrative view schematically showing a semiconductor wafer in its supported state in the second embodiment of a fixing carrier according to the present invention.
[FIG. 17]

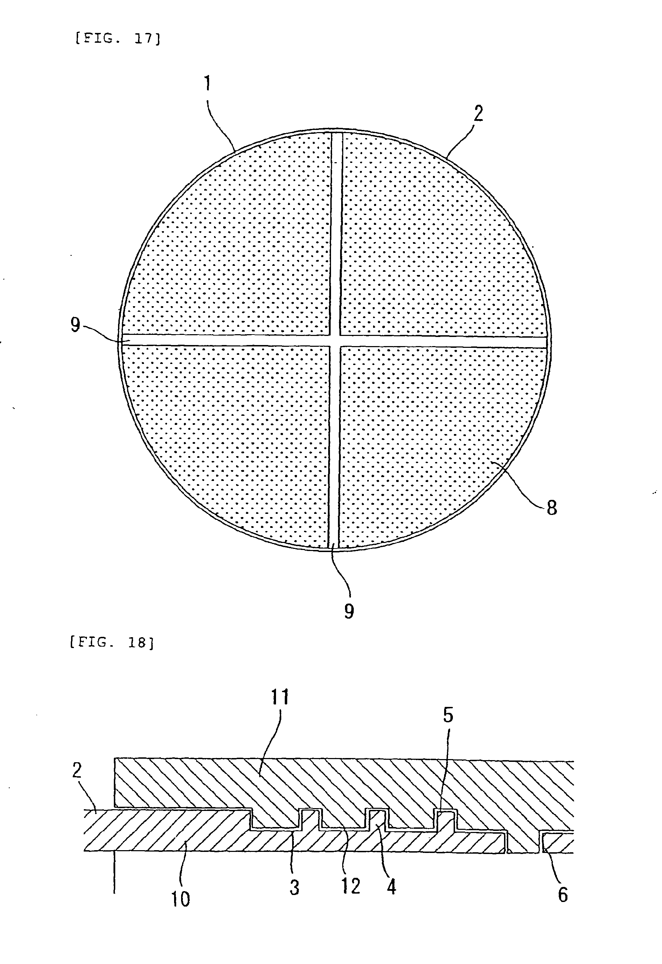

   FIG. 17 is a plan illustrative view schematically showing the second embodiment of a fixing carrier according to the present invention.
[FIG. 18]
   FIG. 18 is a sectional illustrative view schematically showing the embodiment of a manufacturing method of a fixing carrier of the present invention.
[FIG. 19]

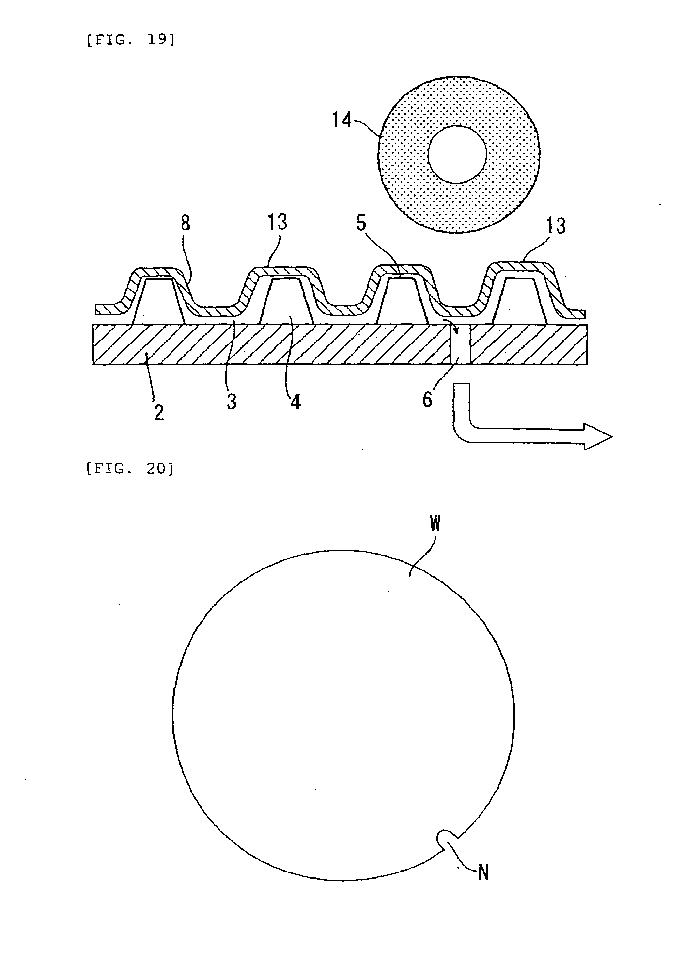

   FIG. 19 is a sectional illustrative view schematically showing a state where the obverse surface of a deformed supporting layer in contact with projections is roughened so as to create a non-stick supporting surface, in the embodiment of a manufacturing method of a fixing carrier according to the present invention.
[FIG. 20]
   FIG. 20 is a plan illustrative view schematically showing a semiconductor wafer in another embodiment of a fixing carrier, a manufacturing method of a fixing carrier, a method of using a fixing carrier and a substrate storage container according to the present invention.

### Description of Reference Numerals

- 1: fixing carrier
- 2: base
- 3: sectioned space
- 4: projection
- 5: front endface
- 6: exhaust passage
- 7: vacuum equipment (negative-pressure source)
- 8: supporting layer
- 9: non-stick line
- 10: resin sheet
- 11: stamper
- 12: concavo-convex surface
- 13: contact area surface
- 14: abrasive roller
- 20: substrate storage container
- 21: container body
- 26: rim portion (opening)
- 29: teeth
- 30: flat plate
- 31: front medium-thick area
- 32: front thick area
- 33: rear medium-thick area
- 34: rear thick area
- 35: rear retainer
- 38: door element
- 39: casing
- 42: locking mechanism
- 46: cover plate
- W: semiconductor wafer (item to be loaded)

### Best Mode for Carrying Out the Invention

Referring next to the drawings a preferred embodiment of the present invention will be described. A fixing carrier 1 in the present embodiment comprising, as shown in FIGS. 1 to 15, a base 2 having rigidity and an elastically deformable supporting layer 8 laid over base 2 and supporting a semiconductor wafer W of 300 mm (12 inch) in diameter, is accommodated into a substrate storage container 20 for semiconductor wafers W.

As shown in FIGS. 1 and 2 semiconductor wafer W is an essentially round silicon wafer of about 750 µm thick with a linear orientation flat O or a notch N cut out. This orientation flat O or notch N provides the functions of determining the crystal orientation and positioning. This semiconductor wafer W is covered by sticking protective tape on its mirror surface that is formed with patterns of circuits while the rear side is background by a backgrinding machine so that the wafer is thinned as thin as 100 µm or lower, then the wafer is supported on supporting layer 8 by an unillustrated dedicated robot.

Fixing carrier 1 is specified to have a total thickness ranging from 0.3 to 2.5 mm, preferably from 0.5 to 1.5 mm, more preferably from 0.5 to 1.2 mm. This has been specified because when the thickness of fixing carrier 1 falls within the above range it is possible to assure a large enough space for insertion of a robot fork when the wafer is accommodated into, and taken out from, substrate storage container 20 while assuring high enough reinforcement of thin semiconductor wafer W. This specification can also make fixing carrier 1 light.

As shown in FIGS. 4 to 6 base 2 of fixing carrier 1 is formed of a predetermined material in a thin flat plate having a round shape, viewed from top, and a size equal to ormarginally greater than semiconductor wafer W, so that it can be positively accommodated in substrate storage container 20. The most part of the surface of the base, other than the periphery, is formed with a flat circular sectioned space 3 that is depressed with a depth of 0.05 mm or greater and laminated with supporting layer 8. A number of projections 4 that support supporting layer 8 in contact therewith and from below are projectively formed at intervals on the bottom of this sectioned space 3 and an exhaust passage 6 that communicates with sectioned space 3 is bored.

In order to be able to withstand pressure changes etc. , accompanied with air transportation, base 2 is formed of a material that is excellent in impact strength, thermal resistance, transparency, etc., for example, soft polycarbonate, polypropylene, polyethylene, acrylic resin, glass-fiber reinforced epoxy resin, aluminumalloy, magnesium alloy, stainless steel, glass or the like.

As shown in FIGS. 4 to 6, each of multiple projections 4 is formed integrally on the bottom of sectioned space 3, in a rigid cylindrical shape or frusto-conical shape having a height in level with that of the peripheral edge of the base 2 surface, forming clearance for air ventilation between projections 4 and 4, and functions to indirectly support semiconductor wafer W via supporting layer 8. Thisprojection 4 is formed to be 0.05 mm or higher. This is because if it is lower than 0.05 mm it is impossible to secure an adequate enough sectioned space 3 and assure smooth enough air ventilation and also there is a concern that deformation of supporting layer 8 may be hindered.

The method of forming projections 4 is not particularly limited and various methods can be considered such as, for example, a method of integrally molding base 2 and projections 4, a method of forming projections 4 by screen printing, a method of forming projections 4 by exposure and development after lamination of a photoresist material, a method of depositing a metal in a predetermined pattern by electrocasting, an etching method by corrosion removal of portions other than those to be formed into projections 4, a sandblast method of removing portions other those to be formed into projections 4, etc.

As shown in the same drawings, exhaust passage 6 is a round through-hole that is bored in the thickness direction of base 2 and located between multiple projections 4, viewed from top and is detachably coupled to vacuum equipment 7 arranged under the base, as shown in FIG. 5, so that this vacuum equipment 7 draws air from sectioned space 3 (as indicated by the arrows in FIGS. 5 and 6). As this vacuum equipment 7 operates to suction, supporting layer 8 deforms concavo-convexly in correspondence with the pattern of multiple projections 4 so as to form clearance for air flow between itself and semiconductor wafer W, thus this clearance enables detachment of semiconductor wafer W held by supporting layer 8.

Vacuum equipment 7 is, for example, a type of vacuum pumps and is incorporated in a backgrinding machine (not shown) for thinning semiconductor wafers W or in an opener (not shown) for mounting substrate storage container 20 and making it open.

As shown in FIGS. 3, 4 and 6, supporting layer 8 is formed of a thin film which is made up of a thin material having elasticity, flexibility, softness, thermal resistance, stickiness, adhesion etc., such as, for example urethane-, fluoro-, silicone-elastomers, has a round shape, viewed from top, and a size equal to or marginally greater than semiconductor wafer W, is added with reinforcing fillers, hydrophobic silica, etc., as required, and is bonded to base 2 at its peripheral edge of the surface and flat front endfaces 5 of every projection 4 so as to detachably come into contact with and hold the obverse or rear surface of semiconductor wafer W.

The manufacturing method of supporting layer 8 is not particularly limited, but it can be formed by forming a layer by calendering, pressing, coating, printing etc., and bonding the layer to the surface of base 2, etc.

Optionally, the portions of supporting layer 8 in contact with semiconductor wafer W, or in other words, the outside surface portions of the layer at which projections 4 are bonded, may be subjected to a process which facilitates semiconductor wafer W to detach from supporting layer 8 even though the layer 8 deforms at removal of semiconductor wafer W. Specifically, it is possible to selectively perform coating of a non-sticky layer, a UV process, or the like, so as to selectively reduce the supporting layer 8's adherence and holding ability at contact points compared to that at non-contact points of supporting layer 8.

Substrate storage container 20 is composed of, as shown in FIGS. 7 to 15, a container body 21 capable of accommodating multiple fixing carriers 1, multiple pairs of teeth 29 arranged either side wall of container body 21 for supporting fixing carriers 1, a rear retainer 35 attached to the rear interior wall of container body 21 for holding fixing carriers 1 at their rear peripheral edges by means of retaining grooves 37 and a door element 38 for opening and closing in a removable manner the front of container body 21.

As shown in FIGS. 7, 8 and 10, container body 21 is molded of a predetermined resin such as polycarbonate, etc., for example into a front-open box having a front opening, so as to accommodate a multiple number (e.g., 25 or 26 sheets) of fixing carriers 1 aligned vertically. Abottomplate 22 having an approximately Y-shape, viewed from top is detachably arranged at the bottom of this container body 21. A plurality of positioning parts 23 are disposed on both sides in the front and at the center in the rear of this bottom plate 22. Each positioning part 23 is positioned with high precision to positioning pins of the backgrinding machine or opener, to which substrate storage container 20 is mounted.

Selectively fitted at the rear part of bottom plate 22 are detachable identifiers 24, which are detected by the sensor of processing equipment to thereby recognize the type of substrate storage container 20, the number of semiconductor wafers W, etc. Each positioning part 23 is shaped in a form having an approximately M-section, approximately inverted V-section, approximately inverted Y-section or in an indented oval form, etc.

As shown in FIG. 7, a flat rectangular robotic flange 25 is attached integrally or removably to container body 21 at the center of the top thereof. This robotic flange 25 is held by an unillustrated automatic transfer mechanism called OHT (overhead hoist transfer) so that substrate storage container 20 is conveyed.

The peripheral part on the open front of container body 21 is formed in a flexed configuration so that it is extended outwards forming a rim portion 26. A plurality of engagement holes 27 for door lock are hollowed at the top and bottom in this rim portion 26. A carriage handle 28 having a thick disk-like form, approximately L-form or sideways U-form is selectively attached on exterior side walls of container body 21. Thus, these carriage handles 28 are held by an operator to carry substrate storage container 20.

As shown in FIGS. 10 to 14, multiple pairs of teeth 29 are arranged vertically with a predetermined pitch on both sides of container body 21, projected inwards from the interior side walls and opposing each other so that the paired teeth on the left and right support base 2 of fixing carrier 1 horizontally.

As shown in FIGS. 11, 12 and 14, each tooth 29 is given in an approximately widely open-V-form or an approximately semi-circular arc shape, viewed from top, and is comprised of a flat plate 30 extended along the side periphery of fixing carrier 1, a flat front medium-thick area 31 integrally formed in the front and interior part on the top of flat plate 30, a flat front thick area 32 located on the side-wall side of container body 21 or the portion integrally formed in the front and outer part on the top of flat plate 30 and outside front medium thick area 31, a rear medium-thick area 33 integrally formed in the rear part of flat plate 30, and a flat and small rear thick area 34 formed in the rear of flat plate 30 and located in front of rear medium-thick area 33 along the side wall of container body 21.

Formed between front medium-thick area 31 and front thick area 32 is a slight vertical step that will be in contact with the side periphery of fixing carrier 1. Front thick area 32 is as high as the thickness of fixing carrier 1, specifically, about 0.3 to 2.5 mm high, so as to function as a stopper that prevents fixing carrier 1 from slipping out from container body 21 when door element 38 is removed.

Formed between front medium-thick area 31 and rear medium-thick area 33 is a slightly indented thin area, which opposes the side periphery of fixing carrier 1 with a slight clearance therebetween. The thus constructed teeth 29. support the base underside horizontally with high precision, on their flat front medium-thick areas 31 and rear medium-thick areas 33.

Rear retainer 35 has a vertically oriented support plate 36 attached to the interior backside wall of container body 21, as shown in FIGS. 10 and 13. This support plate 36 has a plurality of retainer grooves 37 having an approximately V-shaped cross section, arranged vertically, each retainer groove 37 horizontally supporting the rear periphery of fixing carrier 1.

Support plate 36 is molded of a material that is superior in softness, slidability and elasticity than teeth 29 because fixing carriers 1 are individually fitted into contact with retainer grooves 37. Specifically, polybutylene terephthalate, polyethylene terephthalate, polyether etherketone, polyether sulfone, fluorine-containing resins, etc., can be used.

As shown in FIGS. 7, 9 and 15, door element 38 is comprised of a casing 39 having a tray-like section, removably attached into rim portion 26 of container body 21, a pair of locking mechanisms 42 arranged on both the left and right sides on the open front of casing 39 and a cover plate 46 removably attached to the open front of casing 39 to cover locking mechanisms 42, and is press fitted into rim portion 26 of container body 21 to close it in a sealed condition.

Casing 39 is provided in a laterally long, approximately rectangular form, viewed from the front, rounded at its four corners, and has a seal gasket 40 removably fitted on the peripheral wall thereof to fit between container body 21 and door element 38. This seal gasket 40 is given in an endless form made of, for example fluororubber, silicone rubber or the like, and when door element 38 is fitted, the gasket comes into pressure and deforming contact with the inner peripheral surface of rim portion 26 so as to suppress and prevent air contaminated with dust and dirt from flowing into container body 21 from outside. Attached to the center on the rear side of casing 39 is an elastic front retainer 41, which horizontally supports the front periphery of fixing carriers 1 stored in container body 21 by its holder grooves.

As shown in FIG. 15, each locking mechanism 42 includes: a rotary reel 43 which is axially supported at a position to the side on the front of casing 39 and rotated by external actuation with a key of an unillustrated door opening/closing device; a plurality of advancing/retractable bars 44 which are slidably supported by casing 39 and coupled to rotary reel 43 and linearly slide in the vertical direction in and out of door element 38 in accordance with the rotation of rotary reel 43; and engaging claws 45 which are arranged at the distal ends of advancing/retractable bars 44 come in and out from the holes in the peripheral wall of casing 39 to fit into and engage engagement holes 27 in rim portion 26, and lock the door element 38 which fits rim portion 26 of container body 21.

Cover plate 46 is formed in a shape corresponding to the opening front of casing 39 and has rectangular, viewed from the front, actuation passage-holes 47 for locking mechanisms 42, which each bracket the center on the front side of rotary reel 43. The keys of a door opening/closing device are fitted through these paired actuation passage-holes 47 on the left and right.

With the above configuration, when semiconductor wafers W that have been background are transported from one plant to another, first, background semiconductor wafers W are each pressed against supporting layer 8 of fixing carrier 1 by robot so as to be held closely, this fixing carrier 1 is inserted into container body 21 of substrate storage container 20 by robot, then door element 38 is fitted to the front of container body 21. Thereafter, as door element 38 is locked by actuation of locking mechanisms 42, it is possible to transport background semiconductor wafers W from one plant to another.

Since, in the above accommodation, semiconductor wafers W have been loaded in while being closely in contact with fixing carriers 1, it is possible to accommodate the wafers in container body 21 of substrate storage container 20 stably and positively without any fear of the wafers being bent or sagging downward even though they are thin.

Next, when the transported semiconductor wafers W need to be taken out and subjected to dicing, bonding or sealing treatment, door element 38 is removed from container body 21 by unlocking locking mechanisms 42 of door element 38, then fixing carrier 1 is taken out from container body 21 by robot. Thereafter, vacuum equipment 7 is coupled to exhaust passage 6 of fixing carrier 1 to draw out air, whereby it is possible to easily separate semiconductor wafer W from deformed supporting layer 8 of fixing carrier 1, by suctioning the semiconductor wafer W by robot.

In the above configuration, since instead of directly accommodating semiconductor wafers W that are thin and easy to be bent and fragile and easy to break, into container body 21, but by making the wafers in contact with and to be held by rigid fixing carriers 1 and accommodated in an indirect manner, it is possible with a simple configuration to achieve transportation to other plant properly with safety. In particular, since fixing carrier 1 is excellent in strength and rigidity and presents strong enough resistance to severe shipment conditions such as pressure changes etc., it is possible to transport semiconductor wafers W with safety even though it takes a long time to transport from one plant to another, for example.

Further, it is also possible to reduce the time during which dicing tape is adhered or make its use unnecessary, hence there is in effect little risk of the adhesive of dicing tape transferring to the bumps on circuits of semiconductor wafer W. Further, since front medium-thick areas 31 and rear medium-thick areas 33 of teeth 29 hold fixing carrier 1 from its underside at the side peripheral edge thereof, horizontally with high precision, it is possible to prevent fixing carrier 1 frombeing inclined in the vertical direction, hence avoid difficulties in loading and unloading by the robot fork.

Further, since fixing carrier 1 and base 2 are approximately the same size and thin as semiconductor wafer W, it is possible to deal with automatic loading and unloading into an existing substrate storage container 20 which is designed to accommodate non-background semiconductor wafers W, without the necessity of changing size and shape of the existing container.

Next, FIGS. 16 and 17 show the second embodiment of the present invention, where a multiple number of non-sticky lines 9 are formed on part of the deforming area of supporting layer 8 to simplify the attachment and removal of semiconductor wafer W.

Multiple non-sticky lines 9 are formed by partly effecting non-stick treatment on the surface in the deforming area of supporting layer 8, specifically, non-contact areas (depressing portions) of supporting layer 8 that will not come in contact with the front endface 5 of any projection 4, so as to form a cross-shaped pattern, viewed from top, passing through the center of supporting layer 8. Each end of the cross-shaped pattern reaches the periphery of supporting layer 8 and functions as a trigger of removal of semiconductor wafer W. As a non-stick treatment for this supporting layer 8, for example, UV-treatment, surface roughening, lamination of non-sticky rubber, coating of a non-sticky adhesive, etc., can be considered.

. In the above, manufacture of fixing carrier 1, base 2, multiple projections 4 and exhaust passage 6 is formed integrally by molding of a thermoplastic resin sheet 10, for example, and supporting layer 8 of a thin film is bonded to at least the periphery of base 2 and the flat front endface 5 of every projection 4, so that it is possible to produce fixing carrier 1.
In this manufacturing work, a plurality of non-sticky lines 9 have been previously formed in part in the deforming area of supporting layer 8. For the other components the same is done as in the above embodiment, so description is omitted.

Also in this embodiment, it is possible to expect the same operational effect as in the aforementioned embodiment. Further, since non-sticky lines 9 that will not be in close contact with semiconductor wafer W are formed in part on the deforming area of supporting layer 8, it is obviously possible to quickly and positively create air flow passage between non-stick lines 9 of deforming supporting layer 8 and semiconductor wafer W to promptly introduce air and trigger removal of semiconductor W, no matter whether the sticking strength of supporting layer 8 is large or not.

Accordingly, it is possible to expect quick removal of semiconductor wafer W compared to the case where no non-sticky line 9 is formed in the deforming area of supporting layer 8 hence it takes time to remove semiconductor wafer W from being in close contact.

Next, FIGS. 18 and 19 show the third embodiment. In this case a concavo-convex surface 12 of a stamper 11 is heated and pressed into contact with a prepared thermoplastic resin sheet 10, then resin sheet 10 is cooled whilst it is being pressed, to integrally form base 2 with sectioned space 3, multiple projections 4 and exhaust passage 6.

Base 2 is formed into a rigid thin disc having a diameter equal to or marginally greater than semiconductor wafer W, by molding thermoplastic resin sheet 10 using a stamper 11, so that it can be positively accommodated in substrate storage container 20. Resin sheet 10 as the material of this base 2 is not particularly limited, but sheets of a material that is excellent in thermal resistance, impact strength and transparency, for example, softpolycarbonate, polypropylene, polyethylene, acrylic resin, vinyl chloride, etc. may be used.

Supporting layer 8 is basically the same as in the above embodiment, but the obverse surface 13 at the contact portion that is in contact with the front endface 5 of each projection 4 of supporting layer 8 may be selectively roughened in a physical manner by an abrasive roller 14 etc., to form a non-sticky surface. In this case, the arithmetic mean roughness Ra of the surface is specified to be equal to 1.6a or greater, and preferably falls within the range from 1.6 to 12.5a, based on the definition in JIS B0601-2001.

The reason for specifying the arithmetic mean roughness Ra of the obverse surface 13 in contact portions to be equal to 1.6a or greater, and preferably falling within the range from 1. 6 to 12. 5a is that it is possible to provide a non-sticky performance without causing any degradation of supporting layer 8 while removal of semiconductor wafer W can be easily done if roughening falls in this range.

In the above, to manufacture fixing carrier 1, a concavo-convex surface 12 of a stamper 11 is put into press contact with a prepared thermoplastic resin sheet 10 and heated and pressed, then resin sheet 10 is cooled whilst it is being pressed, to integrally formbase 2, sectioned space 3, multiple projections 4 and exhaust passage 6. Hereafter, any unnecessary part is removed from base 2.
Stamper 11 functioning as a die is previously formed with concavo-convex surface 12 for forming base 2, sectioned space 3, multiple projections 4 and exhaust passage 6 all at once, or in other words as a cavity surface.

Upon the molding work, it is preferred that resin sheet 10 is heated and pressed at a temperature ranging from the glass transition temperature Tg of resin sheet 10 to Tg+50 deg. C, and cooled at a temperature equal to or lower than the glass transition temperature Tg to Tg-20 deg. C. This is because if heating and pressing, and cooling are not performed in the specified ranges, the resin of resin sheet 10 fuses completely and is overcome by air pressure, hence draws air thereinto, forming defects in base 2 and/or projections 4 and causing variation in thickness of base 2 and projections 4.

Subsequently, thin-film supporting layer 8 is, at least, bonded along the periphery of the base 2 surface, covering front endfaces 5 of multiple projections 4, to create a space between these multiple projections 4 and supporting layer 8. As a space has been thus formed between multiple projections 4 and supporting layer 8, vacuum equipment 7 is coupled to exhaust passage 6 of base 2 and operated so that supporting layer 8 deforms concavo-convexly along the multiple projections 4. Then, obverse surface 13 of the deformed supporting layer 8 at its contact portion that is in contact with the front endface 5 of each projection 4 is roughened by abrasive roller 14 etc..to make a non-stick treatment, to thereby complete fixing carrier 1. The other part is the same as in the above embodiment so description is omitted.

Also in this embodiment, it is possible to expect the same operational effect as in the aforementioned embodiment. Further, since instead of forming multiple projections 4 on the base 2 surface by a time-consuming process such as sandblasting etc., base 2 and multiple projections 4 are integrally molded, so it is possible to markedly improve productivity and mass producibility. Besides, it is also obvious that multiple projections 4 can be made equal in height with high precision.

When the obverse surface 13 at the contact portions of supporting layer 8 in contact with multiple projections 4 is processed with coating or UV-treatment to form a non-sticky surface, the production cost of the mask will increase depending on the number of projections (e.g., the number of projections amounts to about seventy thousand in the case of a semiconductor wafer W of 300 mm in diameter), and be accompanied by great difficulties in positioning the mask. In contrast, according to the present embodiment, since a non-sticky surface is created by roughening the obverse surface 13 at the contact portions of supporting layer 8, it is possible to cut.down the production cost of the mask and omit the task of mask positioning. This embodiment is apparently able to deal with any pattern of projections 4.

When fixing carrier 1 is used for a background semiconductor wafer W, high-precision flatness is demanded for supporting layer 8 of fixing carrier 1. It is however, markedly difficult to maintain high-precision flatness due to variations of the supporting layer itself and of the thickness of the adhesive. This necessary flatness can be secured if supporting layer 8 is made thin. However, doing so gives rise to new big problems that the durability of supporting layer 8 is greatly lowered and/or the workability and producibility is markedly lowered when supporting layer 8 is bonded to the periphery of base 2.

In contrast, in accordance with the present embodiment, high-precision abrasive roller 14 or the like is used to process the obverse surface 13 at the contact portions of supporting layer 8 with high accuracy, so it is possible to easily provide high-precision flatness of supporting layer 8 while maintaining its durability.

In the above embodiment, though orientation flat O is cut away from the peripheral part of semiconductor wafer W, it is possible to cut out a notch N having an approximately semi-circular shape that has the same function as orientation flat O, at the periphery of semiconductor wafer W, as shown in FIG. 20. It is also noted that base 2 and supporting layer 8 may be either the same or different in diameter. Supporting layer 8 may be either slightly sticky or not.

Base 2, sectioned space 3, multiple projections 4 and exhaust passage 6 in the above embodiment may be formed integrally, but should not be particularly limited. For example, the peripheral edge of base 2 and multiple projections 4 may be formed by etching base 2 laminated with a photoresist layer thereon. Alternatively, after integration of base 2 and multiple projections 4, an exhaust passage 6 may be bored using a drill etc.

Further, a multiple number of non-sticky lines 9 may be formed over the greater part of deforming area of supporting layer 8. The multiple number of non-sticky lines 9 may be either identical or different in length and/or width, and whether they are disconnected or connected should not be particularly limited. Further, it is also possible to change the design of the pattern, length, width etc., of non-sticky lines 9 in accordance with the size of the loaded item to be supported in close contact. Still more, the height of front thick area 32 of each tooth 29 may be specified to be equal to the sum of the thickness of fixing carrier 1 and that of semiconductor wafer W.

## Claims

1. A fixing carrier in combination with a substrate storage container for supporting items to be loaded into the container, wherein the fixing carrier comprises:
a base (2) having a sectioned space (3) formed therein,
a projection (4) disposed in the space and including a flat front end face (5)
a deformable supporting layer (8) laid on the projection to overlie the base, the supporting layer including a contact portion engaging the front end face (5), the contact portion including an obverse surface facing away from the base for supporting the respective item, and
an exhaust passage (6) for drawing air out of the sectioned space to deform the supporting layer into the space
**characterized in that**
the obverse surface (13) is roughened such that the arithmetic mean roughness Ra of the obverse surface falls within a range from 1.6 to 12.5a, based on the definition in JIS B0601-2001, to form a non sticky obverse surface..

2. The fixing carrier according to Claim 1, wherein the base (2) is formed of a flat plate (30) having rigidity and an approximately circular shape, viewed from top while the supporting layer (8) is formed of elastomer.

3. The fixing carrier according to Claim 1 or 2, wherein at least part of the deforming area of the supporting layer (8) is processed with non-stick treatment.

4. The fixing carrier according to Claim 3, wherein the deforming area of the supporting layer (8) is the surface of a non-contact portion where the supporting layer is not in contact with the projection.

5. The fixing carrier according to any one of Claims 1 through 4, wherein the item to be loaded is a semiconductor wafer (W) that has been background.

6. The fixing carrier according to any one of Claims 1 through 5, wherein the projection (4) is as high as 0.05 mm or higher.

7. The fixing carrier according to any one of Claims 1 through 6, wherein multiple projections (4) are provided so as to create clearance between projections.

8. The fixing carrier according to any one of Claims 1 through 7, further including a negative pressure source (7) that is connected to the exhaust passage (6) and draws air out of the sectioned space (3) so as to deform the supporting layer.

9. A fixing carrier manufacturing method for manufacturing any one of the fixing carriers defined in Claims 1 through 8, comprising the steps of:
placing a concavo-convex surface of a stamper into contact with a thermoplastic resin sheet to heat and press it; and
cooling the sheet while pressing it so as to form at least projection(s), among the base, sectioned space, projection(s) and exhaust passage.

10. The fixing carrier manufacturing method according to Claim 9, wherein the resin sheet is heated and pressed at a temperature ranging from the glass transition temperature of the resin to 50 deg. C greater than that and cooled at a temperature lower by 20 deg. C or more than the glass transition temperature.

11. A method of using a fixing carrier **characterized in that** an item to be loaded is transported using a fixing carrier defined in any one of Claims 1 to 7.

12. A substrate storage container for accommodating fixing carriers defined in any one of Claims 1 to 8, comprising:
a front-open container body (21) for accommodating fixing carriers;
a door element (38) which opens and closes the front face of the container body; and
teeth (29) for supporting fixing carriers formed on the walls on both sides of the container body.

13. The substrate storage container according to Claim 12, wherein each tooth (29) is comprised of a flat plate (30) that is provided on the side wall of the container body so as to extend along the side periphery of the fixing carrier, a front medium-thick area (31) that is formed at the front interior side of the flat plate and supports the fixing carrier; and a rear medium-thick area (33) that is formed in the rear part of the flat plate and supports the fixing carrier.

## Patentansprüche

1. Befestigungsträger in Kombination mit einem Substratspeicherbehälter zum Tragen von Artikeln, die in den Behälter zu laden sind, wobei der Befestigungsträger umfasst:
eine Basis (2), die einen darin ausgebildeten abgeteilten Raum (3) aufweist,
einen Vorsprung (4), der in dem Raum angeordnet ist und eine ebene stirnseitige Endfläche (5) aufweist;
eine verformbare tragende Schicht (8), die auf den Vorsprung gelegt wird, um auf der Basis zu liegen, wobei die tragende Schicht einen Kontaktabschnitt aufweist, der die stirnseitige Endfläche (5) in Eingriff nimmt, wobei der Kontaktabschnitt eine vordere Oberfläche aufweist, die von der Basis zum Tragen des jeweiligen Artikels abgewandt ist, und
einen Auslassdurchgang (6) zum Ziehen von Luft aus dem abgeteilten Raum, um die tragende Schicht in den Raum zu verformen,
**dadurch gekennzeichnet, dass**
die vordere Oberfläche (13) aufgeraut ist, sodass der arithmetische Mittenrauwert Ra der vorderen Oberfläche in einen Bereich von 1,6 bis 12,5a fällt, basierend auf der Definition in JIS B0601-2001, um eine nicht haftende vordere Oberfläche zu bilden.

2. Befestigungsträger gemäß Anspruch 1, bei dem die Basis (2) aus einer ebenen Platte (30) gebildet ist, die Steifigkeit und eine annähernd kreisförmige Gestalt von oben betrachtet aufweist, während die tragende Schicht (8) aus Elastomer gebildet ist.

3. Befestigungsträger gemäß Anspruch 1 oder 2, bei dem mindestens ein Teil des Verformbereichs der tragenden Schicht (8) mit einer Antihaftbehandlung verarbeitet ist.

4. Befestigungsträger gemäß Anspruch 3, bei dem der Verformbereich der tragenden Schicht (8) die Oberfläche eines Nicht-Kontakt-Abschnitts ist, wobei die tragende Schicht nicht in Kontakt mit dem Vorsprung ist.

5. Befestigungsträger gemäß einem der Ansprüche 1 bis 5, bei dem der zu ladende Artikel ein Halbleiterwafer (W) ist, der Hintergrund war.

6. Befestigungsträger gemäß einem der Ansprüche 1 bis 5, bei dem der Vorsprung (4) so hoch wie 0,05 mm oder höher ist.

7. Befestigungsträger gemäß einem der Ansprüche 1 bis 6, bei dem mehrere Vorsprünge (4) bereitgestellt werden, um Freiraum zwischen Vorsprüngen zu erzeugen.

8. Befestigungsträger gemäß einem der Ansprüche 1 bis 7, ferner mit einer Unterdruckquelle (7), die mit dem Auslassdurchgang (6) verbunden ist und Luft aus dem abgeteilten Raum (3) zieht, um die tragende Schicht zu verformen.

9. Befestigungsträger-Herstellungsverfahren zur Herstellung eines der in Ansprüchen 1 bis 8 definierten Befestigungsträger, mit folgenden Schritten:
Platzieren einer konkav-konvexen Oberfläche einer Matrize in Kontakt mit einer thermoplastischen Harzfolie, um sie zu erwärmen und zu pressen; und
Kühlen der Folie während sie gepresst wird, um mindestens einen Vorsprung/Vorsprünge zwischen der Basis, dem abgeteilten Raum, dem Vorsprung/den Vorsprünge und dem Auslassdurchgang zu bilden.

10. Befestigungsträger-Herstellungsverfahren gemäß Anspruch 9, bei dem die Harzfolie erhitzt und gepresst wird bei einer Temperatur, die von der Glasübergangstemperatur des Harzes bis zu 50 Grad C größer als diese reicht und bei einer Temperatur gekühlt wird, die um 20 Grad C oder mehr niedriger als die Glasübergangstemperatur ist.

11. Verfahren zur Verwendung eines Befestigungsträgers, **dadurch gekennzeichnet, dass** ein zu ladender Artikel mit einem Befestigungsträger transportiert wird, der in einem der Ansprüche 1 bis 7 definiert ist.

12. Substratspeicherbehälter zum Unterbringen von Befestigungsträgem, die in einem der Ansprüche 1 bis 8 definiert sind, mit:
einem an der Stirnseite offenen Behälterkörper (21) zum Unterbringen von Befestigungsträgem;
einem Türelement (38), das die Stirnfläche des Behälterkörpers öffnet und schließt; und
Zähnen (29) zum Tragen von Befestigungsträgern, die auf den Wänden auf beiden Seiten des Behälterkörpers ausgebildet sind.

13. Substratspeicherbehälter gemäß Anspruch 12, bei dem jeder Zahn (29) umfasst:
eine ebene Platte (30), die auf der Seitenwand des Behälterkörperkörpers bereitgestellt wird, um sich entlang des seitlichen Umfangs des Befestigungsträgers zu erstrecken, einen stirnseitigen Bereich mittlerer Dicke (31), der an der stirnseitigen Innenseite der ebenen Platte ausgebildet ist und den Befestigungsträger trägt; und einen hinteren Bereich mittlerer Dicke (33), der in dem hinteren Teil der ebenen Platte ausgebildet ist und den Befestigungsträger trägt.

## Revendications

1. Support de fixation en association à un contenant de stockage de substrat pour supporter des articles destinés à être chargés dans le contenant, dans lequel le support de fixation comprend :
une base (2) possédant un espace segmenté (3) formé dans celle-ci,
une saillie (4) disposée dans l'espace et comprenant une face d'extrémité avant plate (5),
une couche de support déformable (8) déposée sur la saillie pour recouvrir la base, la couche de support comprenant une partie de contact entrant en prise avec la face d'extrémité avant (5), la partie de contact comprenant une surface recto orientée dans une direction opposée à la base pour supporter l'article respectif, et
un passage d'échappement (6) pour aspirer de l'air hors de l'espace segmenté pour déformer la couche de support dans l'espace,
**caractérisé en ce que** la surface recto (13) est rugosifiée de sorte que la rugosité moyenne arithmétique Ra de la surface recto soit dans une plage de 1,6 à 12,5a, en fonction de la définition dans la norme JIS B0601-2001, pour former une surface recto non collante.

2. Support de fixation selon la revendication 1, dans lequel la base (2) est formée d'une plaque plate (30) possédant une rigidité et une forme approximativement circulaire, en vue de dessus alors que la couche de support (8) est formée d'élastomère.

3. Support de fixation selon la revendication 1 ou 2, dans lequel au moins une partie de la zone de déformation de la couche de support (8) est traitée avec un traitement non collant.

4. Support de fixation selon la revendication 3, dans lequel la zone de déformation de la couche de support (8) est la surface d'une partie sans contact où la couche de support n'est pas en contact avec la saillie.

5. Support de fixation selon l'une quelconque des revendications 1 à 4, dans lequel l'article destiné à être chargé est une tranche à semi-conducteur (W) dont le dos a été meulé.

6. Support de fixation selon l'une quelconque des revendications 1 à 5, dans lequel la hauteur de la saillie (4) est égale ou supérieure à 0,05 mm.

7. Support de fixation selon l'une quelconque des revendications 1 à 6, dans lequel de multiples saillies (4) sont prévues afin de créer un espace libre entre des saillies.

8. Support de fixation selon l'une quelconque des revendications 1 à 7, comprenant en outre une source de pression négative (7) qui est raccordée au passage d'échappement (6) et aspire de l'air hors de l'espace segmenté (3) afin de déformer la couche de support.

9. Procédé de fabrication de supports de fixation pour fabriquer un quelconque des supports à fixation selon les revendications 1 à 8, comprenant les étapes consistant à :
placer une surface concave-convexe d'une machine à estamper en contact avec une feuille de résine thermoplastique pour la chauffer et la presser ; et
refroidir la feuille durant son pressage afin de former une ou des saillies, parmi la base, l'espace segmenté, la ou les saillies et le passage d'échappement.

10. Procédé de fabrication de support de fixation selon la revendication 9, dans lequel la feuille de résine est chauffée et pressée à une température variant de la température de transition vitreuse de la résine à une température plus élevée que celle-ci de 50°C et refroidie à une température plus basse que la température de transition vitreuse de 20°C ou plus.

11. Procédé d'utilisation de support de fixation, **caractérisé en ce qu'**un article destiné à être chargé est transporté en utilisant un support de fixation selon l'une quelconque des revendications 1 à 7.

12. Contenant de stockage de substrat pour loger des supports de fixation selon l'une quelconque des revendications 1 à 8, comprenant :
un corps de contenant ouvert à l'avant (21) pour loger des supports de fixation ;
un élément porte (38) qui ouvre et ferme la face avant du corps de contenant ; et
des dents (29) pour supporter des supports de fixation formés sur les parois sur les deux côtés du corps de contenant.

13. Contenant de stockage de substrat selon la revendication 12, dans lequel chaque dent (29) est composée d'une plaque plate (30) qui est prévue sur la paroi latérale du corps de contenant afin de s'étendre le long la périphérie latérale du support de fixation, une zone épaisse médiane avant (31) qui est formée sur le côté intérieur avant de la plaque plate et supporte le support de fixation; et une zone épaisse médiane arrière (33) qui est formée dans la partie arrière de la plaque plate et supporte le support de fixation.
